# FASCICULE DE BREVET EUROPEEN

(11) **EP 3 924 757 B1**
(45) Date de publication et mention de la délivrance du brevet: **22.03.2023**
(21) Numéro de dépôt: 20706991.5
(22) Date de dépôt: 14.02.2020
(51) Int. Cl.: G02B 1/00, C03C 23/00, G02B 1/12, G02B 5/18

(54) **MÉTASURFACES OPTIQUES, PROCÉDÉS ET SYSTÈMES DE FABRICATION ASSOCIÉS**
OPTISCHE METAOBERFLÄCHEN UND ZUGEHÖRIGE HERSTELLUNGSVERFAHREN UND -SYSTEME
OPTICAL METASURFACES, AND ASSOCIATED MANUFACTURING METHODS AND SYSTEMS

(30) Priorité: 15.02.2019 FR 1901570
(43) Date de publication de la demande: 22.12.2021
(73) Titulaire: Université d'Aix-Marseille, 13007 Marseille (FR); Centre national de la recherche scientifique, 75016 Paris (FR); Ecole Centrale De Marseille (ECM), 13013 Marseille (FR); Multiwave Innovation, 13013 Marseille (FR)
(72) Inventeur: MIKHEEVA, Elena, 13006 Marseille (FR); ABDEDDAIM, Redha, 13008 Marseille (FR); ENOCH, Stefan, 13013 Marseille (FR); LUMEAU, Julien, 13013 Marseille (FR); VOZNYUK, Ivan, 13008 Marseille (FR); ANTONAKAKIS, Tryfon, 1207 Genève (CH)
(74) Mandataire: Osha Liang
(86) Numéro de dépôt international: PCT/EP2020/053988
(87) Numéro de publication internationale: WO 2020/165448

(56) Documents cités:
- EP-A1- 3 226 042
- EP-A1- 3 226 042
- WO-A1-2007/021022
- WO-A1-2007/021022
- US-A1- 2017 063 039
- US-A1- 2017 063 039

## Description

La présente invention concerne le domaine des métasurfaces optiques, et plus particulièrement la fabrication à façon de métasurfaces optiques diélectriques.

### Etat de la technique

Pour le contrôle de faisceaux lumineux et plus largement le contrôle des ondes électromagnétiques, les composants traditionnels, par exemple les prismes ou les lentilles, génèrent des retards de phase accumulés lors de la propagation dans le matériau dont ils sont formés. Ainsi, pour un prisme ou une lentille par exemple, l'épaisseur traversée dans le matériau d'indice de réfraction donné varie continûment afin d'augmenter le chemin optique par rapport à la propagation dans l'air. La fonction optique d'un composant est donc entièrement déterminée par ses propriétés intrinsèques, comme par exemple la forme et l'indice de réfraction.

Aujourd'hui, les nanotechnologies permettent de concevoir une nouvelle classe de composants optiques, appelés « métasurfaces optiques » formés d'éléments optiques 2D comprenant des nanostructures, par exemple des nano piliers ou autres particules en matériau diélectrique ou métallique, formant des réseaux d'éléments résonants ou quasi-résonants. Les métasurfaces optiques, décrites par exemple dans l'article de revue de Minovich et al. , « Functional and nonlinear optical metasurfaces », Laser Photonics Rev., 1-19 (2015) permettent notamment des changements abrupts de phase, d'amplitude et/ou de polarisation sur une échelle d'épaisseur de l'ordre de la longueur d'onde. Elles offrent ainsi par rapport aux composants optiques traditionnels une grande flexibilité dans le contrôle du front d'onde en plus d'être des composants plans de très faible épaisseur, c'est-à-dire inférieure ou égale à la longueur d'onde. Le contrôle de la propagation de la lumière dans les métasurfaces optiques requiert une structuration à l'échelle sub-longueur d'onde dans deux des trois dimensions de l'espace, rendant le défi technologique particulièrement ardu.

Par exemple, la demande de brevet publiée US 2017/0212285 décrit des métasurfaces optiques diélectriques comportant des éléments résonants répartis selon une matrice 2D et permettant de contrôler la phase d'ondes incidentes dans le domaine infrarouge. Les éléments résonants sont structurellement différents et répartis de façon à générer le profil de phase désiré. Par exemple, les éléments résonants présentent des dimensions latérales différentes pour générer le profil de phase souhaité.

Dans les métasurfaces optiques telles que décrites dans le document précité, afin de produire un contrôle local de la phase, il est ainsi nécessaire de contrôler parfaitement, à l'échelle de la longueur d'onde, chaque élément résonant de la métasurface. Cette contrainte rend la méthode difficilement réalisable à grande échelle. Aussi, ces technologies sont souvent cantonnées à des démonstrateurs de laboratoire.

Un objectif de la présente description est de proposer une nouvelle méthode de fabrication d'une métasurface optique qui permette de s'affranchir d'au moins une partie des difficultés de l'art antérieur. Les documents EP 3 226 042 A1, US 2017/063039 A1 et WO 2007/021022 A1 sont pertinents pour la présente invention.

### Résumé de l'invention

Selon un premier aspect, la présente description concerne un procédé de fabrication d'une métasurface optique configurée pour fonctionner dans une bande spectrale d'utilisation donnée, le procédé comprenant les étapes suivantes :
- obtention d'une matrice 2D de motifs comprenant chacun une ou plusieurs nanostructures formant des éléments diélectriques résonants dans ladite bande spectrale d'utilisation, lesdites nanostructures étant formées dans au moins un matériau diélectrique photosensible, ledit au moins un matériau diélectrique photosensible présentant un indice de réfraction variable par exposition à au moins une onde électromagnétique d'inscription ayant une longueur d'onde comprise dans une bande spectrale de photosensibilité;
- exposition de ladite matrice 2D à une onde électromagnétique d'inscription ayant au moins une longueur d'onde dans ladite bande spectrale de photosensibilité, ladite onde d'inscription présentant dans un plan de la matrice 2D une distribution spatiale d'énergie fonction d'un profil de phase recherché de sorte que, suite à ladite exposition, chaque motif de la matrice 2D produit sur une onde électromagnétique incidente ayant une longueur d'onde dans la bande spectrale d'utilisation, une variation de phase correspondant à une variation d'indice de réfraction subie par ledit motif lors de ladite exposition.

Le procédé de fabrication ainsi décrit permet une fabrication à façon d'une métasurface optique, le contrôle local de l'indice de réfraction étant fait a posteriori, c'est-à-dire après l'obtention de la matrice 2D de motifs comprenant des éléments diélectriques résonants, en fonction de la fonction optique recherchée pour la métasurface optique. Il est ainsi possible de produire des métasurfaces optiques de grandes dimensions, c'est-à-dire supérieures à quelques mm².

Selon un ou plusieurs exemples de réalisation, lesdits motifs comprenant un ou plusieurs éléments diélectriques résonants sont identiques, arrangés périodiquement selon deux directions, avec une période sub longueurs d'onde selon chaque direction. Il est ainsi possible de fabriquer une matrice 2D uniforme dans un premier temps et de contrôler à façon le profil de phase que l'on veut générer au moyen de variations locales de l'indice de réfraction.

Une métasurface optique est un composant optique nanostructuré à l'échelle sub-longueur d'onde dans deux des trois dimensions de l'espace, dans lequel les nanostructures, par exemple des nano piliers ou autres particules en matériau diélectrique ou métallique, formant des réseaux d'éléments résonants ou quasi-résonants.

Par « motifs identiques », on entend des motifs identiques avant l'exposition, c'est-à-dire des motifs d'éléments diélectriques résonants qui comprennent le même arrangement d'éléments diélectriques résonants, avec les mêmes formes et les mêmes dimensions pour les éléments diélectriques résonants d'un motif à l'autre.

Dans d'autres exemples de réalisation, il est également possible, grâce au procédé de fabrication selon la présente description, d'appliquer des variations locales d'indice de réfraction sur une matrice 2D non nécessairement uniforme, par exemple pour corriger un profil de phase initial.

Par sub longueur d'onde, on comprend de manière générale et sauf autre indication une période inférieure à la longueur minimale de la bande spectrale d'utilisation.

Dans la présente description, on appelle "matériau diélectrique" un matériau qui présente un indice de réfraction avec une partie réelle dominante contrairement à un métal dans lequel la partie imaginaire de l'indice de réfraction domine. Ainsi, sauf aux énergies de photons supérieures à la largeur de bande interdite, les semi-conducteurs sont des matériaux diélectriques à faible pertes.

Dans la présente description, on appelle « matériau diélectrique photosensible » un matériau diélectrique qui présente un indice de réfraction variable par exposition à au moins une onde électromagnétique d'inscription. La bande spectrale de photosensibilité comprend l'ensemble des longueurs d'onde pour lesquelles l'indice de réfraction est variable.

Selon un ou plusieurs exemples de réalisation, l'indice de réfraction peut varier jusqu'à des valeurs de 2%, avantageusement 3%, dans la bande spectrale de photosensibilité. Selon un ou plusieurs exemples de réalisation, l'obtention de la matrice 2D comprend le dépôt sur un substrat dudit au moins un matériau diélectrique photosensible et la formation desdites nanostructures dans ledit au moins un matériau diélectrique photosensible.

Selon un ou plusieurs exemples de réalisation, l'obtention de la matrice 2D comprend le dépôt sur un substrat d'une couche ou un empilement de couches en matériau diélectrique déposé(e) sur ledit substrat, la couche ou ledit empilement de couches comprenant ledit au moins un matériau diélectrique photosensible.

Selon un ou plusieurs exemples de réalisation, l'obtention de la matrice 2D comprend le dépôt sélectif du matériau diélectrique photosensible sur un substrat, par exemple au moyen d'un masque, pour former les éléments diélectriques résonants.

Selon un ou plusieurs exemples de réalisation, ledit empilement de couches comprend au moins une couche formée dudit au moins un matériau diélectrique photosensible et une ou plusieurs couches additionnelles, par exemple une couche anti-reflet et/ou une couche d'accroche entre le substrat et ladite au moins une couche formée dudit au moins un matériau diélectrique photosensible. Selon un ou plusieurs exemples de réalisation, ledit empilement de couches comprend au moins une deuxième couche formée d'un deuxième matériau diélectrique photosensible.

Selon un ou plusieurs exemples de réalisation, l'obtention de la matrice 2D comprend le dépôt sur un substrat dudit au moins un matériau diélectrique photosensible.

Selon un ou plusieurs exemples de réalisation, le substrat comprend un matériau transparent dans la bande spectrale d'utilisation. Ainsi, par exemple, le substrat peut comprendre l'un au moins des matériaux suivants : silice, verre, verre de chalcogénure, ZnSe (Séléniure de zinc), polymère.

Un matériau est dit transparent dans une bande spectrale au sens de la présente description si pour chaque longueur d'onde de ladite bande spectrale, au moins 50% d'une onde à ladite longueur d'onde est transmise, préférentiellement au moins 80% et plus préférentiellement au moins 90%.

Selon un ou plusieurs exemples de réalisation, l'obtention de la matrice 2D comprend la formation desdites nanostructures directement dans un substrat comprenant ledit au moins un matériau diélectrique photosensible.

Selon un ou plusieurs exemples de réalisation, le substrat comprend une ou plusieurs couches additionnelles, par exemple une couche anti-reflet.

Selon un ou plusieurs exemples de réalisation, la bande spectrale d'utilisation est comprise dans la bande spectrale de transparence dudit au moins un matériau diélectrique photosensible, c'est à dire la bande spectrale comprenant les longueurs d'onde supérieures à une longueur d'onde correspondant à l'énergie de bande interdite (ou " gap " optique).

En pratique, la bande spectrale d'utilisation se situe autour de la bande spectrale de résonance des éléments diélectriques résonants mais n'est pas limitée à ladite bande spectrale de résonance.

Selon un ou plusieurs exemples de réalisation, la bande spectrale d'utilisation présente une largeur comprise entre 1 nm et 20 nm, voire 1 nm à 100 nm. En fonction des matériaux utilisés et des éléments diélectriques résonants, elle peut être comprise dans la bande spectrale visible, le proche infrarouge ou l'infrarouge moyen, par exemple entre 400 nm et 15 µm.

Selon un ou plusieurs exemples de réalisation, la bande spectrale de photosensibilité est comprise dans la bande spectrale d'absorption linéaire dudit au moins un matériau diélectrique photosensible, c'est à dire les longueurs d'onde inférieures à la longueur d'onde correspondant à l'énergie de bande interdite. On parle de photosensibilité linéaire.

Dans un matériau diélectrique à photosensibilité linéaire, la variation de l'indice de réfraction dépend de la quantité d'énergie absorbée par le matériau. Il est alors possible d'utiliser toute source lumineuse pour l'émission de l'onde électromagnétique d'inscription, une augmentation la puissance d'un facteur N permettant de diminuer le temps d'exposition de la matrice 2D avec une durée N fois inférieure. Par exemple, la source d'émission comprend des diodes électroluminescentes, des diodes laser, des laser continus ou impulsionnels, une lampe Xénon.

Selon un ou plusieurs exemples de réalisation, la bande spectrale de photosensibilité linéaire est comprise entre 300 nm et 1000 nm.

Des exemples de matériaux diélectriques à photosensibilité linéaire comprennent par exemple et de façon non limitative les verres de chalcogénure (e.g. Ge₂₅As₃₀S₄₅, Ge₃₃As₁₂Se₅₅, A_{S2}S₃, ...). On peut également citer des verres oxydes, par exemple des photo-thermo-réfractifs décrits dans J. *Lumeau et al.* [Ref.3], par exemple le Foturan^{®} ou des matériaux polymères photosensibles, par exemple du PQ:PMMA décrit dans G. J. Steckman et al. , "Characterization of phenanthrenequinone-dopedpoly(methyl méthacrylate) for holographie memory," Opt. Lett.23(16), 1310-1312 (1998);. Selon un ou plusieurs exemples de réalisation, la bande spectrale de photosensibilité est comprise dans une bande spectrale d'absorption non linéaire dudit au moins un matériau diélectrique photosensible, par exemple une absorption à deux photons ou multi-photons. On parle de photosensibilité non linéaire.

Lors d'un mécanisme d'absorption non linéaire, une forte densité de puissance (en général obtenue à l'aide d'un laser pulsé) est utilisée et la variation de l'indice de réfraction dépend à la fois de l'intensité locale d'exposition (effet non-linéaire) et de la quantité d'énergie absorbée par le matériau (effet de photosensibilité).

Une source lumineuse pour l'émission de ladite onde d'inscription est par exemple, dans le cas d'une photosensibilité non linéaire, une source impulsionnelle émettant des impulsions avec une énergie par impulsion suffisante pour déclencher des phénomènes d'absorption multi-photons ; les impulsions présentent par exemple une durée d'impulsion inférieure à 100 ns, avantageusement inférieure à 10 ns et une intensité lumineuse supérieure à quelques MW/cm², avantageusement supérieure à 100 MW/cm².

Selon un ou plusieurs exemples de réalisation, la bande spectrale de photosensibilité non linéaire est comprise entre 300 nm et 2 µm.

Selon un ou plusieurs exemples de réalisation, l'exposition de la matrice 2D à l'onde d'inscription comprend la projection à travers un masque d'amplitude donnée, par exemple un masque similaire à celui utilisé en photolithographie, par exemple un masque de chrome.

Selon un ou plusieurs exemples de réalisation, l'exposition de la matrice 2D à l'onde d'inscription comprend une illumination point par point de la matrice, par exemple en utilisant un balayage d'un laser focalisé.

Selon un ou plusieurs exemples de réalisation, l'exposition de la matrice 2D à l'onde d'inscription comprend l'utilisation d'un modulateur spatial de lumière du type matrice à cristaux liquides ou de micro-miroirs.

Selon un ou plusieurs exemples de réalisation, le profil de phase recherché est un profil de phase multiniveaux, par exemple un profil de phase binaire, à 4 niveaux, 8 niveaux, ou plu généralement 2^{N} niveaux ou N entier supérieur ou égal à 1.

Selon un ou plusieurs exemples de réalisation, le profil de phase recherché est configuré pour générer dans la bande spectrale d'utilisation, au moins l'une des fonctions optiques suivantes : lentille convergente ou divergente, convertisseur de faisceau, séparateur de faisceau, image projetée, par exemple une mire, une grille, ou plus généralement toute distribution d'intensité formant une image, par exemple en champ lointain.

Selon un ou plusieurs exemples de réalisation, les éléments diélectriques résonants sont formés de plots, par exemple des plots parallélépipédiques à section rectangulaire ou carré, ou des plots cylindriques, par exemple de section circulaire ou ovale.

Selon un ou plusieurs exemples de réalisation, une dimension au moins desdits éléments diélectriques résonants est sub longueur d'onde.

Selon un ou plusieurs exemples de réalisation, la métasurface optique est configurée pour fonctionner en réflexion.

Selon un ou plusieurs exemples de réalisation, la métasurface optique est configurée pour fonctionner en transmission.

Selon un ou plusieurs exemples de réalisation, le procédé comprend en outre une étape de contrôle en temps réel des variations d'indice de réfraction locales subies par au moins une région de la matrice 2D lors de ladite exposition. Cette étape permet de s'affranchir d'une étape de calibration lors de la fabrication de ladite métasurface. Par exemple, le contrôle comprend l'illumination d'au moins une région de la matrice 2D avec une onde électromagnétique présentant au moins une longueur d'onde dans la bande spectrale d'utilisation et l'observation de la fonction optique résultante. Selon un ou plusieurs exemples de réalisation, la métasurface optique ainsi obtenue est reconfigurable pour une nouvelle application.

Selon un deuxième aspect, la présente description concerne une métasurface optique configurée pour générer un profil de phase donné dans une bande spectrale d'utilisation donnée, ladite métasurface étant obtenue avec un procédé de fabrication selon l'un quelconque des exemples de réalisation du procédé selon le premier aspect.

La présente description concerne de façon plus générale une métasurface optique configurée pour générer un profil de phase donné dans une bande spectrale d'utilisation donnée, ladite métasurface comprenant :
- un substrat ;
- une matrice 2D de nanostructures formant des éléments diélectriques résonants, lesdites nanostructures étant formées dans au moins un matériau diélectrique photosensible déposé sur ledit substrat ; et dans laquelle :
- lesdites nanostructures sont arrangées sous forme de motifs identiques répétés périodiquement selon deux directions, avec une période sub longueur d'onde selon chaque direction, chaque motif présentant une variation d'indice de réfraction donnée par rapport à un indice de réfraction de référence, de sorte que chaque motif de la matrice 2D produit sur une onde électromagnétique incidente ayant une longueur d'onde dans la bande spectrale d'utilisation, une variation de phase correspondant à ladite variation d'indice de réfraction.

Selon un ou plusieurs exemples de réalisation, lesdites nanostructures sont formées de plots parallélépipédiques ou cylindriques.

Par « motifs identiques », on comprend des motifs de nanostructures qui comprennent le même arrangement de nanostructures, avec les mêmes formes et les mêmes dimensions pour les nanostructures d'un motif à l'autre.

Selon un troisième aspect, la présente description concerne un système de fabrication d'une métasurface optique pour la mise en oeuvre du procédé selon le premier aspect, le système comprenant :
- un support apte à recevoir ladite matrice 2D de motifs comprenant chacun une ou plusieurs nanostructures ;
- une source d'émission d'une onde électromagnétique, ayant au moins une longueur d'onde dans ladite bande spectrale de photosensibilité dudit au moins un matériau diélectrique photosensible ;
- un dispositif d'inscription, placé entre la source d'émission et le support, configuré pour moduler l'amplitude et/ou la phase de l'onde électromagnétique pour former ladite onde d'inscription présentant dans le plan de la matrice 2D la distribution spatiale d'énergie fonction dudit profil de phase recherché.

Selon un ou plusieurs exemples de réalisation, ledit dispositif d'inscription comprend un modulateur spatial d'ondes électromagnétiques et un contrôleur dudit modulateur spatiale d'ondes électromagnétiques. Par exemple, ledit modulateur spatiale d'ondes électromagnétiques comprend une matrice à cristaux liquides ou une matrice de micro-miroirs.

Selon un ou plusieurs exemples de réalisation, ledit dispositif d'inscription comprend un dispositif de balayage à deux dimensions d'un faisceau d'inscription, pour l'illumination point par point de la matrice 2D.

Selon un ou plusieurs exemples de réalisation, ledit dispositif d'inscription comprend un masque d'amplitude.

Selon un ou plusieurs exemples de réalisation, le système de fabrication d'une métasurface optique comprend en outre un système optique d'imagerie configuré pour contrôler en temps réel le procédé de fabrication de la métasurface optique.

Selon un ou plusieurs exemples de réalisation, ledit système optique d'imagerie est configuré pour mesurer la variation de phase induite sur une région de calibration préalablement définie sur la métasurface.

### Brève description des figures

D'autres avantages et caractéristiques de l'invention apparaîtront à la lecture de la description, illustrée par les figures suivantes :
[Fig. 1] représente un schéma illustrant un exemple de procédé de fabrication d'une métasurface optique selon la présente description ;
[Fig. 2] représente un schéma illustrant un exemple de métasurface optique selon la présente description ;
[Fig. 3] représente un schéma illustrant un exemple de système de fabrication d'une métasurface optique selon la présente description ;
[Fig. 4A] représente une courbe montrant le coefficient de transmission calculé à incidence normale, pour une matrice 2D d'une métasurface selon un exemple de la présente description ;
[Fig. 4B] représente des courbes montrant le coefficient de transmission calculé à incidence normale, pour une matrice 2D d'une métasurface selon un exemple de la présente description, pour différentes hauteurs des éléments diélectriques résonants ;
[Fig. 4C] représente des courbes montrant d'une part le coefficient de transmission et d'autre part la variation de changement de phase, calculés à incidence normale, pour une matrice 2D d'une métasurface selon un exemple de la présente description, pour différents temps d'exposition ;
[Fig. 5A] représente des images illustrant un premier exemple de profil de phase, binaire et une distribution spatiale d'intensité en champ lointain correspondante ; [Fig. 5B] représente des images illustrant un deuxième exemple de profil de phase, à 4 niveaux et une distribution spatiale d'intensité en champ lointain correspondante

### Description détaillée de l'invention

Dans la description détaillée qui suit, seuls certains exemples de réalisation sont décrits en détails pour assurer la clarté de l'exposé mais ces exemples ne visent pas à limiter la portée générale des principes ressortant de la présente description.

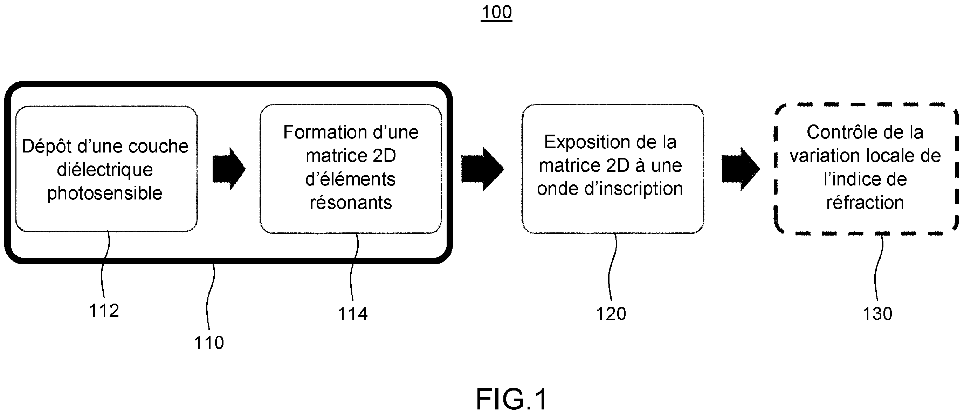

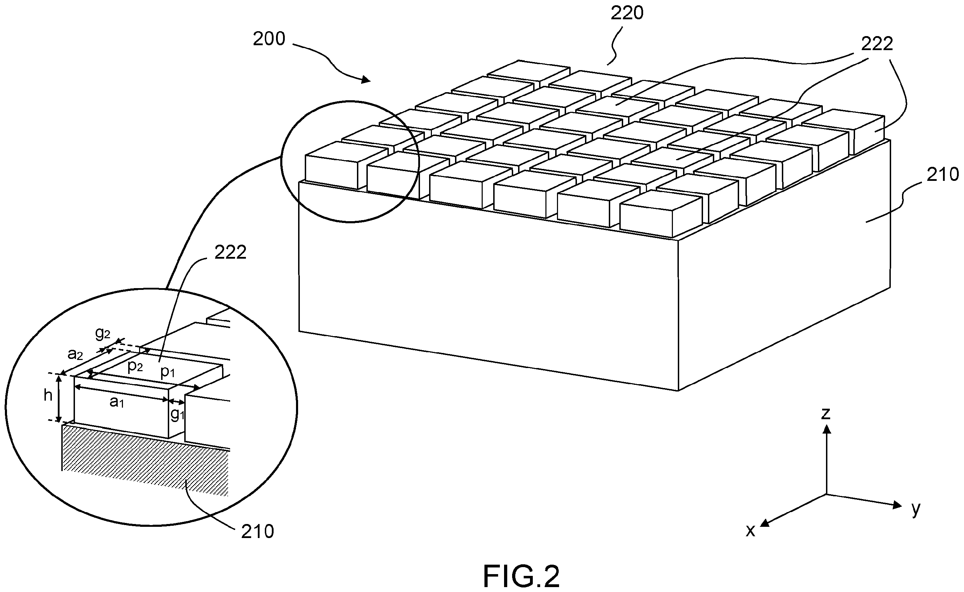

La Fig. 1 représente un schéma illustrant un exemple de procédé de fabrication 100 d'une métasurface optique selon la présente description et la Fig. 2 illustre un exemple d'une métasurface optique 200 selon la présente description.

L'exemple de procédé de fabrication 100 d'une métasurface optique illustré sur la Fig. 1 comprend une étape 110 d'obtention d'une matrice 2D de nanostructures formant des éléments diélectriques résonants dans une bande spectrale d'utilisation donnée puis l'exposition 120 de la matrice 2D ainsi obtenue à une onde d'inscription.

L'étape 110 comprend selon un exemple le dépôt 112, sur un substrat 210 (Fig. 2), d'une couche en matériau diélectrique photosensible dans une bande spectrale de photosensibilité donnée, ledit matériau photosensible étant déposé sous forme de couche minces par exemple. Le dépôt peut être fait par des méthodes physiques telles que l'évaporation ou la pulvérisation ou par des méthodes chimiques telles que la PE-VCD (Plasma-Enhanced Chemical vapor déposition). Dans le cas de polymères, des procédés d'enduction centrifuge (« spin-coating ») ou d'enduction par trempage (« dip-coating ») sont également envisageables.

Le matériau diélectrique photosensible présente des propriétés de changement d'indice de réfraction lorsqu'il est exposé à une onde électromagnétique donnée, appelée onde d'inscription dans la présente demande. Typiquement, on recherche des matériaux diélectriques dont l'indice de réfraction peut varier d'une quantité minimale donnée, par exemple 2% à 3% de la valeur de l'indice de réfraction nominale. Divers matériaux diélectriques peuvent être envisagés pour cet effet. Il peut s'agir par exemple de matériaux à photosensibilité linéaires inorganiques tels que des verres de chalcogénure (e.g. Ge₃₃As₁₂Se₅₅ (Germanium-Arsenic-Selenium, As₂S₃ (trisulfure d'arsenic), etc.) ou organiques tel que le Polyméthacrylate de méthyle dopé phenanthrenequinone (PQ:PMMA). Il est également possible d'utiliser la photosensibilité non-linéaire de matériaux exposés à des impulsions ultra-courtes, typiquement inférieures à 1 ps. On peut citer par exemple la silice (SiO₂), voir D. Homoelle et al. , "Infrared photosensitivity in silica glasses exposed to femtosecond laser pulses," Opt. Lett. 24, 1311-1313 (1999), le niobia (Nb₂O₅).

Le substrat est par exemple un matériau organique (PMMA...) ou inorganique (silice, chalcogénure...) compatible avec le matériau déposé en couche mince déposé en surface (adhésion) ou bien lui-même photosensible s'il est utilisé comme support pour la production du réseau de surface.

Le matériau photosensible pourra être utilisé soit seul, soit en combinaison avec d'autre matériaux en couches minces. Pour exemple, on peut citer l'emploi de couches d'accroche (Chrome, Oxyde de magnésium (MgO)...) pour rendre le substrat et la couche compatible, l'emploi de structures multicouches sur ou sous la couche photosensible afin de limiter les pertes par réflexion aux interfaces (structures antireflets) et/ou augmenter les phénomènes de résonance et/ou augmenter la plage d'utilisation de la métasurface (achromatique).

L'étape 110 comprend ensuite la formation 114 d'une matrice 2D d'éléments diélectriques résonants dans la couche en matériau diélectrique.

Dans d'autres exemples de réalisation, l'obtention 110 de la matrice 2D peut comprendre le dépôt sur un substrat du matériau diélectrique photosensible à travers un masque, par exemple un masque de résine, pour former les éléments diélectriques résonants.

Selon un autre exemple de réalisation, les éléments diélectriques résonants peuvent être formés directement dans un substrat solide lui-même en matériau diélectrique photosensible.

Dans l'exemple de la Fig. 2, la matrice 2D d'éléments résonants est référencée 220. Les éléments diélectriques résonants 222 sont arrangés sous forme de motifs agencés périodiquement selon deux directions perpendiculaires (x, y). Dans cet exemple, chaque motif comprend un seul élément diélectrique résonant 222. Chaque élément diélectrique résonant présente dans cet exemple une forme de plot de section rectangulaire, de côtés *a₁, a₂* et de hauteur *h,* Deux plots adjacents sont séparés selon chaque direction respectivement d'une distance *p₁, p₂* de telle sorte que la période selon chaque direction vaut *p*₁= *a*₁+*g*₁ *et p*₂= *a₂*+*g*₂*,* où *p₁, p₂* sont sub longueur d'onde. Bien entendu, d'autres formes, agencements et dimensions sont possibles pour les éléments diélectriques résonants 222 illustrés sur la Fig. 2. Notamment, la Fig. 2 montre des éléments 222 de forme parallélépipédique. Néanmoins, les éléments 222 peuvent présenter d'autres formes, par exemple des plots cylindriques de section ronde, ovale, etc. Par ailleurs, dans l'exemple de la Fig. 2, l'élément diélectrique 222 est confondu avec un motif. Il est possible cependant d'avoir plusieurs éléments diélectriques résonants de formes et/ou de dimensions différentes au sein d'un motif. Dans des exemples de réalisation, un motif identique en termes de nombre, formes et dimensions desdits éléments diélectriques résonants est reproduit avec une période donnée sub longueur d'onde dans les deux directions de la matrice, par exemple mais non nécessairement une période identique.

L'étape d'exposition 120 permet d'introduire des variations locales de l'indice de réfraction au niveau d'un motif et ainsi contrôler la phase transmise.

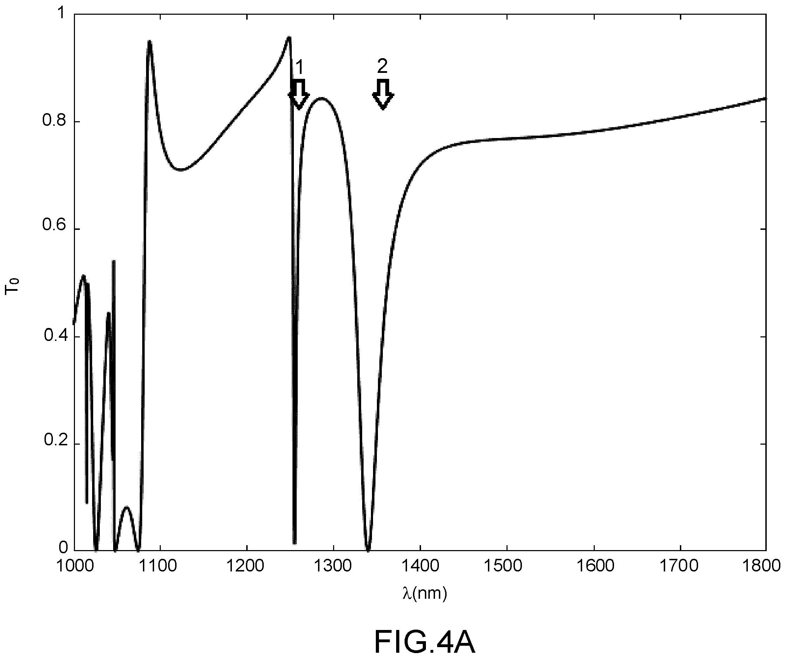

De manière générale, la conception de la matrice 2D (forme et dimensions des éléments résonants, agencement sous forme de motifs, période, etc.) dépend de la longueur d'onde (ou du domaine spectral) d'utilisation et de la variation de phase souhaitée. Des méthodes de conception seront décrites plus en détails par la suite, en référence aux Figs. 4A - 4C.

Une méthode connue pour la formation de la matrice 2D d'éléments résonants dans la couche en matériau diélectrique comprend par exemple une étape de lithographie électronique afin de former dans une résine les motifs de tailles nanométriques recherchées puis le transfert des motifs dans la couche en matériau diélectrique par gravure ionique. Une autre méthode comprend la génération des éléments résonants par nano-impression. Plus précisément, on utilise un moule pour la réplication du motif de base sur une large surface. Il est intéressant de noter que quelle que soit le profil de phase recherché pour la métasurface optique que l'on cherche à fabriquer, le même motif de base peut être utilisé puisque la variation de phase locale sera contrôlée par la distribution des variations d'indice photoinduites.

Une fois la matrice 2D d'éléments résonants obtenue, l'étape 120 d'exposition de la matrice 2D à une onde d'inscription permet de créer le profil de phase recherché pour la génération de la fonction optique désirée (par exemple, matrice de points, mire, vortex, image projetée...). Le profil de phase recherché est similaire à celui qui est généralement calculé pour la génération d'éléments diffractifs optiques ou d'hologramme générés numériquement, tels que décrits par exemple dans l'ouvrage de Bernard Kress, Patrick Meyrueis, "Applied digital optics", chapitre 6 "Digital Diffractive Optics: Numeric Type", John Wiley & Sons, 2009. Le profil de phase est un profil multiniveaux, par exemple binaire, ou à nombre de niveaux supérieurs typiquement 2^{N}.

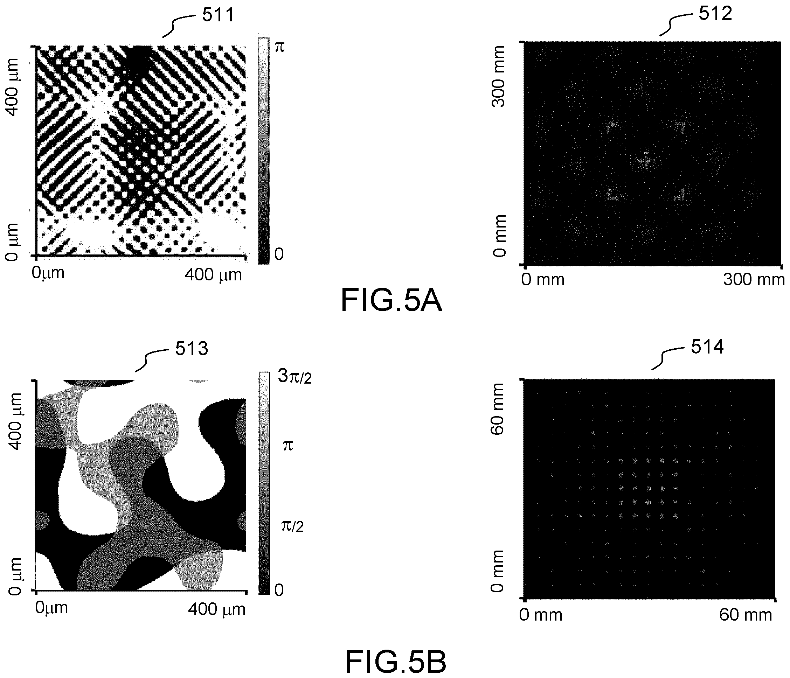

Des exemples de profils de phase et des fonctions optiques correspondantes seront décrits en référence à la Fig. 5.

L'exposition de la matrice 2D comprend une exposition sélective spatialement et/ou temporellement pour obtenir une variation locale de l'indice de réfraction photoinduite.

La durée d'exposition peut par exemple être fonction de la variation d'indice de réfraction à photo-induire pour produire une variation de phase donnée. Celle-ci sera donc donnée par la structure de type réseau calculée (relation variation de phase variation d'indice) et les propriétés de photosensibilité du matériau. Dans le cas de photosensibilité linéaire, la durée d'exposition peut être fonction de la densité d'énergie de l'exposition tandis que dans le cas de photosensibilité non-linéaire, la durée d'exposition peut être fonction de densité d'énergie de l'exposition et de l'intensité du faisceau d'exposition, comme exposé dans L. Siiman et al. , "Nonlinear photosensitivity of photo-thermo-refractive glass by high intensity laser irradiation", Journal of Non Crystalline Solids, 354, 4070-4074 (2008) dans le cas d'un verre photo-thermo-réfractif

Par exemple, le contrôle du dosage d'exposition permet de générer différents niveaux de variations d'indice de réfraction qui permettront de générer sur une onde lumineuse de longueur d'onde comprise dans la bande spectrale d'utilisation, des valeurs discrètes de variations de phase. L'exposition sélective peut être faite par exemple au moyen d'un modulateur spatial de lumière, comme cela sera décrit plus en détails par la suite.

Dans la métasurface optique ainsi obtenue, la modulation de la variation d'indice de réfraction pour former le profil de phase voulu dans la bande spectrale d'utilisation est réalisée a postériori ce qui limite les erreurs de réalisation des structures diélectriques de base.

Par ailleurs, le procédé 100 de fabrication d'une métasurface optique peut comprendre, de façon optionnelle un contrôle optique in-situ 130, c'est-à-dire un contrôle de la variation locale de l'indice de réfraction, ce qui permet de contrôler, en temps réel, le processus de fabrication de la métasurface optique et ainsi éliminer les étapes de calibration nécessaires à la fabrication.

Dans ce cas, un laser émettant dans la bande spectrale d'utilisation de la métasurface vient éclairer la métasurface en cours de fabrication. Une caméra peut être placée en aval de la métasurface, combinée ou non avec une lentille, pour mesurer le profil d'intensité transmis par la métasurface en champ lointain. L'exposition est arrêtée quand le profil d'intensité obtenu est identique à celui calculé théoriquement. Ce critère d'arrêt peut être défini comme une fonction de mérite définissant l'écart moyen entre la réponse théorique et expérimentale. Une autre méthode peut consister à mesurer, en aval de la métasurface, le déphasage entre les zones exposées et non exposées à l'aide d'un interféromètre ou un système de mesure de front d'onde de type Shack-Hartmann. Le contrôle peut se faire dans une région donnée de la métasurface optique.

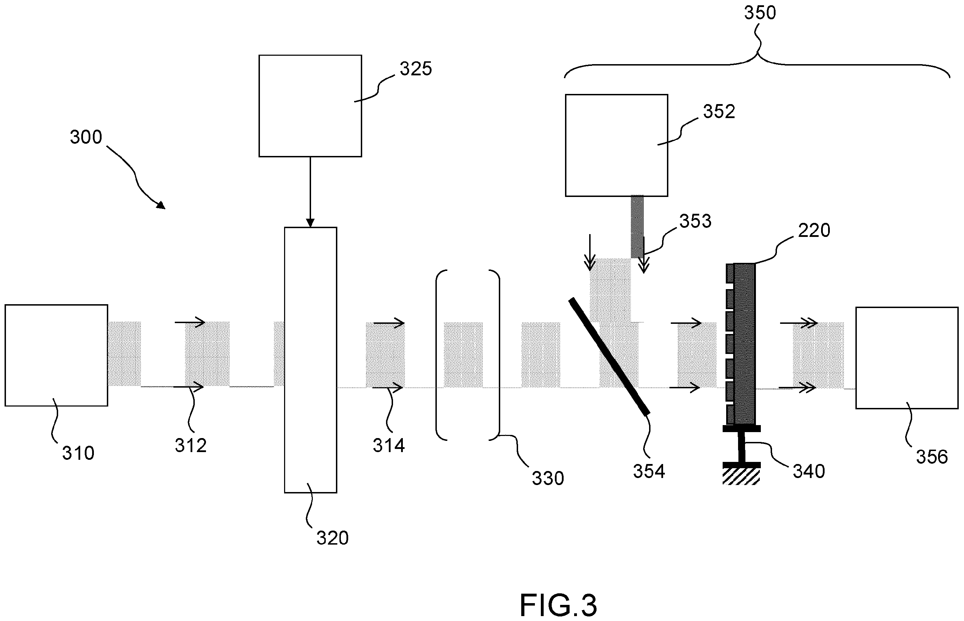

La FIG. 3 représente schématiquement un exemple d'un système de fabrication 300 d'une métasurface optique configuré pour la mise en oeuvre d'un procédé de fabrication selon la présente description.

Le système de fabrication 300 comprend un support 340 configuré pour recevoir une matrice 2D 220 d'éléments diélectriques résonants 222. Comme expliqué précédemment, la matrice 2D est conçue pour produire, après exposition à au moins une onde électromagnétique d'inscription, une variation de phase sur une onde électromagnétique incidente ayant une longueur d'onde dans la bande spectrale d'utilisation, selon un profil de phase recherché.

Le système de fabrication 300 comprend en outre au moins une source d'émission 310 d'au moins une onde électromagnétique 312 ayant au moins une longueur d'onde dans la bande spectrale de photosensibilité du ou des matériau(x) diélectrique(s) formant lesdits éléments diélectriques résonants.

La source d'émission comprend par exemple une diode laser, un laser, une diode électroluminescente, fibrée ou non et un système de mise en forme du faisceau constitué de lentilles ou miroirs afin de produire un faisceau d'exposition de taille et de profil d'intensité adaptés.

Le système de fabrication 300 comprend également un dispositif d'inscription 320, placé entre la source d'émission 310 et le support 340, configuré pour moduler l'amplitude et/ou la phase de l'onde électromagnétique 312 et, optionnellement, un contrôleur 325 configuré pour contrôler ledit dispositif d'inscription 320 pour produire une onde d'inscription 314 présentant dans le plan de la matrice 2D la distribution d'énergie fonction du profil d'indice et donc du profil de phase recherché.

Le dispositif d'inscription 320 peut comprendre un modulateur spatial de lumière ou SLM (selon l'abréviation de l'expression anglo-saxonne « spatial light modulator ») configuré pour moduler l'onde d'inscription en amplitude afin d'obtenir la densité d'énergie recherchée. Dans le cas d'éléments binaires (0 et π), le profil en intensité de l'onde d'inscription pourra être figé pendant un temps d'exposition donné. Dans le cas d'inscription de profils de phase présentant plus que 2 niveaux, le SLM pourra être reconfiguré après chaque exposition correspondant à un niveau de phase.

Le dispositif d'inscription 320 peut comprendre également une matrice de micro-miroirs, chaque micro-miroir étant configuré pour être basculé pendant un temps d'exposition donné par le contrôleur, afin de former la distribution spatiale d'énergie recherchée.

Le dispositif d'inscription 320 peut comprendre également un système de balayage point à point de la matrice 2D. Dans ce cas, le faisceau d'inscription sera focalisé sur la métasurface à inscrire avec un diamètre de spot adapté à la taille des zones à inscrire, c'est-à-dire égal ou inférieur à la plus petite zone. La zone est comprise ici comme une région destinée à produire une variation de phase uniforme, par exemple 0 ou π dans le cas d'un profil de phase binaire. La métasurface sera maintenue fixe et le spot sera alors balayé sur la surface, à l'aide par exemple de miroirs galvanométriques, et la durée d'exposition de chaque point sera adaptée en fonction de la variation de phase attendue. Une autre option pourra consister à maintenir le faisceau d'inscription fixe et balayer l'échantillon.

Le dispositif d'inscription 320 peut comprendre également un masque d'amplitude fixe, du type masque de chrome similaire à ceux utilisés en photolithographie.

Dans l'exemple illustré sur la Fig. 3, le système de fabrication 300 comprend également un système optique relai 330, comprenant par exemple un ou plusieurs objectifs ou lentilles, configuré pour projeter l'onde d'inscription sur la matrice 2D. par exemple, système optique relai 330 comprend un système optique de grandissement donné.

Le contrôleur 325 est configuré pour contrôler le dispositif d'inscription 320 selon le profil d'intensité recherché pour l'onde d'inscription. Le contrôleur comprend par exemple un ordinateur mis en oeuvre pour l'exécution d'instructions. Ces instructions peuvent être stockées sur tout support de stockage lisible par le contrôleur.

Dans l'exemple de la Fig. 3, le système de fabrication comprend en outre un dispositif optique 350 configuré pour contrôler en temps réel les variations d'indice de réfraction subie par lesdits motifs de ladite matrice 2D lors de l'exposition. Le dispositif optique de contrôle 350 comprend par exemple une source d'illumination 352, configurée pour émettre une onde de contrôle 352 présentant une longueur d'onde dans la bande spectrale d'utilisation. Le dispositif optique de contrôle 350 comprend en outre un détecteur 356, par exemple un détecteur bidimensionnel, par exemple une caméra CCD ou CMOS sur lequel peut être imagé en temps réel la fonction optique formée par la métasurface optique en cours de fabrication.

Les Figs. 4A à 4C représentent des courbes qui illustrent des étapes pour la conception d'une matrice 2D d'éléments diélectriques résonants en vue de la fabrication d'une métasurface optique selon la présente description.

Une première étape de la conception d'une matrice 2D est le choix d'un ou plusieurs matériau(x) diélectrique(s) photosensible(s) pour la formation des éléments résonants. On choisira avantageusement des matériaux diélectriques photosensibles avec des variations importantes de l'indice de réfraction, typiquement jusqu'à 2% à 3% de l'indice de réfraction, lorsqu'ils sont illuminés avec des ondes lumineuses présentant des bandes spectrales comprises dans les domaines de longueur d'onde visible, proche infrarouge et moyen infrarouge.

Lorsque le ou les matériau(x) diélectrique(s) photosensible(s) sont déposés sur un substrat, on choisira également le matériau du substrat pour sa compatibilité physico-chimique avec le(s) matériau(x) photosensible(s), éventuellement sa transparence dans la bande spectrale d'utilisation.

Comme expliqué précédemment, le milieu diélectrique peut comprendre plusieurs matériaux diélectriques dont le(s) matériau(x) diélectrique(s) photosensible(s), éventuellement un traitement antireflet à l'interface air/matériau diélectrique photosensible et/ou une couche d'accroche à l'interface substrat/matériau diélectrique photosensible.

Une deuxième étape comprend le choix des nanostructures (formes, dimensions, agencement) pour former les éléments diélectriques résonants et la modélisation de la réponse en transmission et/ou en réflexion de la structure ainsi formée pour identifier les plages de longueurs d'onde de résonance. Bien entendu, la modélisation prendra en compte les caractéristiques (indice de réfraction, épaisseur de couche) de l'ensemble des matériaux formant le milieu diélectrique, notamment le substrat et le(s) matériau(x) diélectrique(s) photosensible(s) ainsi que les matériaux diélectriques additionnels (anti-reflet, interface). La modélisation peut être faite avec des logiciels connus dans le commerce, par exemple CST MICROWAVE STUDIO^{®}, COMSOL Multiphysics^{®}, ANSYS HFSS^{®}.

Les nanostructures sont agencées sous formes de motifs arrangés de façon périodique selon les deux directions de la matrice 2D. On choisira des périodes inférieures à la longueur d'onde minimale de la plage de longueur d'onde d'utilisation souhaitée pour travailler en transmission ou en réflexion à l'ordre zéro et éviter des pertes d'énergie dans des ordres de diffraction supérieurs.

La Fig. 4A représente ainsi une courbe montrant le coefficient de transmission en fonction de la longueur d'onde pour une matrice 2D d'éléments de forme rectangulaire déposée sur un substrat, telle que représentée par exemple sur la Fig. 2. Plus précisément pour le calcul de la FIG. 4A, des cubes de dimension *a* = 600 nm sont agencés de façon périodique, avec une période égale *à p* = 700 nm dans chacune des directions. L'indice de réfraction du matériau diélectrique photosensible est *n* = 2,35 et l'indice de réfraction du substrat est *n_{Sub}* = 1,5. La matrice 2D est illuminée en incidence normale et on calcule le coefficient de transmission de la lumière de propageant à incidence normale.

Comme illustré sur la Fig. 4A, la courbe de transmission montre deux creux numérotés « 1 » et « 2 » dans la région d'ordre zéro correspondant aux positions des résonances des éléments. On montre que la première résonance (1) est principalement une résonance dipolaire électrique et la seconde résonance (2) est principalement une résonance dipolaire magnétique.

La Fig. 4A illustre aussi les autres effets physiques résultant de la nature périodique de la structure. Pour les longueurs d'onde λ < *p*· *n_{Sub}* (dans cet exemple 1050 nm), la lumière transmise est répartie entre plusieurs ordres diffractés. Par conséquent, la métasurface sera conçue pour travailler avec des longueurs d'onde d'utilisation supérieures à une longueur d'onde donnée, dans cet exemple 1050 nm, pour n'avoir que l'ordre zéro transmis.

Des travaux ont montré, voir Gomez-Medina et al., "Electric and magnetic dipolar response of germanium nanospheres: interférence effects, scattering anisotropy, and optical forces", Journal of Nanophotonics, 5(1), 053512 (2011), qu'en variant le rapport d'aspect des motifs de base (ratio entre hauteur *h* et dimensions latérales a), il est possible de décaler les résonances dipolaires électriques et magnétiques, l'une par rapport à l'autre, et de trouver le point où elles coïncident spectralement.

Une troisième étape consiste alors à déterminer, pour des nanostructures de formes données, la hauteur h à laquelle les résonances électriques et magnétiques coïncident spectralement.

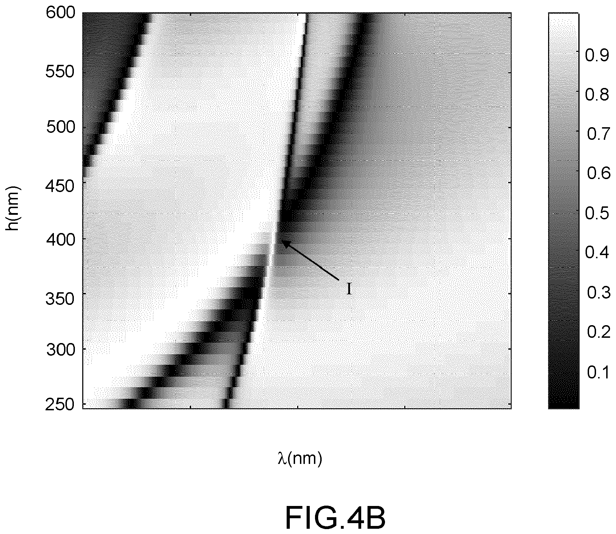

A titre d'illustration, la Fig. 4B montre la transmission calculée à l'ordre 0 pour des nanostructures à section carrée de côté égal à *a* = 600 nm et une hauteur h variable entre 250 nm et 600 nm.

Comme cela apparaît sur la Fig. 4B, à mesure que la hauteur h des nanostructures diminue, les résonances dipôles électriques et magnétiques se déplacent vers des longueurs d'onde plus basses avec des vitesses différentes. Aux alentours de *h* = 330 nm, ces deux minima se superposent autour d'un point référencé I sur la Fig. 4B. Le point I correspond par ailleurs à un maximum local de transmission.

Une quatrième étape consiste à calculer, autour de la hauteur h déterminée précédemment, l'évolution de la transmission en fonction de la longueur d'onde à l'ordre zéro pour un motif de base (dans l'exemple choisi un plot parallélépipédique de section carrée) dans le cas où le matériau n'est pas exposé (n = 2,35) et dans le cas où le matériau est exposé (n = 2,42)

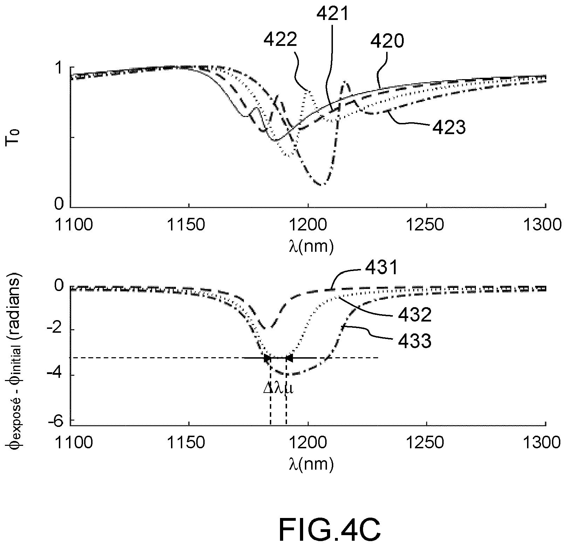

La Fig. 4C illustre (courbes du haut) le coefficient de transmission T₀ mesuré à l'ordre zéro lorsque la matrice 2D n'est pas exposée (courbe 420) et lorsque la matrice 2D a été exposée à différentes densités d'énergie, respectivement 1 J/cm² (courbe 421), 4 J/cm² (courbe 422) et 20 J/cm² (courbe 423).

La Fig. 4C illustre par ailleurs (courbes du bas) les variations de phase ϕ_{exposé} - ϕᵢₙᵢₜᵢₐₗ subi par la lumière incidente sur un motif de base à incidence normal, pour les mêmes densités d'énergie. Plus précisément, les courbes 431, 432, 433 illustrent les variations de phase ϕ_{exposé} - ϕᵢₙᵢₜᵢₐₗ subis par une onde incidente, pour les densités d'énergie, respectivement 1 J/cm² (courbe 431), 4 J/cm² (courbe 432) et 20 J/cm² (courbe 433). On observe une variation maximale de la phase ϕ_{exposé} - ϕᵢₙᵢₜᵢₐₗ égale à ~4 radians. De plus, cette variation de phase est associée à une transmission qui peut être maintenue au-dessus de 50% voire proche de la transmission initiale. Cette variation est suffisante pour la conception d'un élément optique binaire sans pertes.

Ainsi par exemple, si l'on considère la courbe 433 montrant la variation de phase obtenue pour une exposition de 4 J/cm², on observe que dans une plage de longueur d'onde Δλᵤ centrée sur environ 1185 nm et de largeur environ 10 nm, la variation de phase est de π +/- 15% et la transmission reste autour de 50%. Il est donc possible de réaliser un profil de phase binaire dans cette plage de longueur d'onde d'utilisation. Cette approche peut être étendue à des déphasages arbitraires entre 0 et 2π, dont la valeur est contrôlée par l'indice de réfraction du matériau.

Les Figs 5A et 5B illustrent deux exemples de profils de phase à enregistrer dans la matrice 2D à l'aide de variations d'indice photoinduites pour l'obtention de métasurfaces optiques selon la présente description. Les distributions spatiales d'intensité calculées en champ lointain, pour chacun des profils de phase sont représentées.

Ainsi, la Fig. 5A illustre un premier profil de phase 511 binaire (variations de phase entre 0 et π) permettant de réaliser une image en champ lointain 512 en forme de mire. La Fig. 5B illustre un deuxième profil de phase 513 à 4 niveaux de phase (0, π/2, π et 3π/2) permettant de réaliser une image en champ lointain 514 en forme une matrice 5×5 points.

Bien que décrite à travers un certain nombre d'exemples de réalisation, le procédé de fabrication d'une métasurface optique et le dispositif pour la mise en oeuvre dudit procédé comprennent différentes variantes, modifications et perfectionnements qui apparaîtront de façon évidente à l'homme de l'art, étant entendu que ces différentes variantes, modifications et perfectionnements font partie de la portée de l'invention telle que définie par les revendications qui suivent.

## Revendications

1. Procédé de fabrication (100) d'une métasurface optique (200) configurée pour fonctionner dans une bande spectrale d'utilisation (Δλᵤ) donnée, le procédé comprenant les étapes suivantes :
- obtention (110) d'une matrice 2D (220) de motifs comprenant chacun une ou plusieurs nanostructures formant des éléments diélectriques résonants (222) dans ladite bande spectrale d'utilisation, lesdites nanostructures étant formées dans au moins un matériau diélectrique photosensible, ledit au moins un matériau diélectrique photosensible présentant un indice de réfraction variable par exposition à au moins une onde électromagnétique d'inscription ayant une longueur d'onde comprise dans une bande spectrale de photosensibilité;
- exposition (120) de ladite matrice 2D à une onde électromagnétique d'inscription (314) ayant au moins une longueur d'onde dans ladite bande spectrale de photosensibilité, ladite onde d'inscription (314) présentant dans un plan de la matrice 2D une distribution spatiale d'énergie fonction d'un profil de phase recherché de sorte que, suite à ladite exposition, chaque motif de la matrice 2D produit sur une onde électromagnétique incidente ayant une longueur d'onde dans la bande spectrale d'utilisation, une variation de phase correspondant à une variation d'indice de réfraction subie par ledit motif lors de ladite exposition.

2. Procédé de fabrication d'une métasurface optique selon la revendication 1, dans lequel l'obtention de la matrice 2D comprend le dépôt (112) sur un substrat (210) dudit au moins un matériau diélectrique photosensible et la formation (114) desdites nanostructures dans ledit au moins un matériau diélectrique photosensible.

3. Procédé de fabrication d'une métasurface optique selon la revendication 1, dans lequel l'obtention de la matrice 2D comprend la formation desdites nanostructures dans un substrat comprenant ledit au moins un matériau diélectrique photosensible.

4. Procédé de fabrication d'une métasurface optique selon l'une quelconque des revendications précédentes, dans lequel ledit profil de phase est multiniveaux.

5. Procédé de fabrication d'une métasurface optique selon l'une quelconque des revendications précédentes, comprenant en outre une étape (130) de contrôle en temps réel des variations d'indice de réfraction subies par les motifs d'au moins une région de la matrice 2D lors de ladite exposition.

6. Procédé de fabrication d'une métasurface optique selon l'une quelconque des revendications précédentes, dans lequel lesdits motifs sont identiques, arrangés périodiquement selon deux directions, la période selon chaque direction étant sub longueur d'onde.

7. Métasurface optique (200) configurée pour fonctionner dans une bande spectrale d'utilisation (Δλᵤ) donnée, ladite métasurface comprenant :
- un substrat (210),
- une matrice 2D (220) de nanostructures formant des éléments diélectriques résonants (222)formées dans au moins un matériau diélectrique photosensible déposé sur ledit substrat (210) ; et dans laquelle
- lesdites nanostructures (222) sont arrangées sous forme de motifs identiques répétés périodiquement sur le substrat selon deux directions, avec une période sub longueur d'onde selon chaque direction, chaque motif présentant une variation d'indice de réfraction donnée par rapport à un indice de réfraction de référence, de sorte que chaque motif de la matrice 2D produit sur une onde électromagnétique incidente ayant une longueur d'onde dans la bande spectrale d'utilisation, une variation de phase correspondant à ladite variation d'indice de réfraction.

8. Métasurface optique (200) selon la revendication 7, dans laquelle les nanostructures (222) sont formées de plots parallélépipédiques ou cylindriques.

9. Système (300) de fabrication d'une métasurface optique (200) pour la mise en oeuvre du procédé de fabrication selon l'une quelconque des revendications 1 à 6, le système comprenant :
- un support (340) apte à recevoir ladite matrice 2D (220);
- une source d'émission (310) d'une onde électromagnétique (312) ayant au moins une longueur d'onde dans ladite bande spectrale de photosensibilité dudit au moins un matériau diélectrique photosensible;
- un dispositif d'inscription (320), placé entre la source d'émission (310) et le support (340), configuré pour moduler l'amplitude et/ou la phase de l'onde électromagnétique (312) pour former ladite onde d'inscription (314) présentant dans le plan de la matrice 2D la distribution spatiale d'énergie fonction dudit profil de phase recherché.

10. Système de fabrication selon la revendication 9, dans lequel ledit dispositif d'inscription (320) comprend un modulateur spatial d'ondes électromagnétiques et un contrôleur (325) configuré pour contrôler ledit modulateur spatial.

11. Système selon l'une quelconque des revendications 9 à 10, comprenant en outre un dispositif optique (350) configuré pour contrôler en temps réel les variations d'indice de réfraction subies par lesdits motifs d'au moins une région de ladite matrice 2D (220) lors de ladite exposition.

## Patentansprüche

1. Verfahren zur Herstellung (100) einer optischen Metaoberfläche (200), die konfiguriert ist, um in einem vorgegebenen spektralen Nutzungsband (Δλᵤ) betrieben zu werden, wobei das Verfahren die folgenden Schritte aufweist:
- Erzeugen (110) einer 2D-Matrix (220) mitMustern, die jeweils eine oder mehrere Nanostrukturen aufweisen, die dielektrische Resonanzelemente (222) in dem spektralen Nutzungsband bilden, wobei die Nanostrukturen in mindestens einem lichtempfindlichen dielektrischen Material ausgebildet sind, wobei das mindestens eine lichtempfindliche dielektrische Material einen Brechungsindex aufweist, der durch Belichtung mit mindestens einer elektromagnetischen Beschriftungswelle mit einer Wellenlänge innerhalb eines lichtempfindlichen Spektralbandes variabel ist;
- Belichten (120) der 2D-Matrix mit einer elektromagnetischen Beschriftungswelle (314) mit mindestens einer Wellenlänge in dem lichtempfindlichen Spektralband, wobei die Beschriftungswelle (314) in einer Ebene der 2D-Matrix eine räumliche Energieverteilung aufweist, die von einem gewünschten Phasenprofil abhängig ist, wodurch infolge der Belichtung jedes Musters der 2D-Matrix bei einer einfallenden elektromagnetischen Welle mit einer Wellenlänge in dem spektralen Nutzungsband eine Phasenänderung erzeugt wird, welche einer Änderung des Brechungsindex entspricht, die das Muster bei der Belichtung erfährt.

2. Verfahren zur Herstellung einer optischen Metaoberfläche nach Anspruch 1, wobei das Erzeugen der 2D-Matrix das Aufbringen (112) des mindestens einen lichtempfindlichen dielektrischen Materials auf ein Substrat (210) und das Ausbilden (114) der Nanostrukturen in dem mindestens einen lichtempfindlichen dielektrischen Material beinhaltet.

3. Verfahren zur Herstellung einer optischen Metaoberfläche nach Anspruch 1, wobei das Erzeugen der 2D-Matrix das Ausbilden der Nanostrukturen in einem Substrat beinhaltet, welches das mindestens eine lichtempfindliche dielektrische Material aufweist.

4. Verfahren zur Herstellung einer optischen Metaoberfläche nach einem der vorhergehenden Ansprüche, wobei das Phasenprofil mehrstufig ist.

5. Verfahren zur Herstellung einer optischen Metaoberfläche nach einem der vorhergehenden Ansprüche, ferner aufweisend einen Schritt (130) zur Echtzeitüberwachung der Änderungen des Brechungsindex, welche die Muster von mindestens einem Bereich der 2D-Matrix nach der Belichtung erfahren.

6. Verfahren zur Herstellung einer optischen Metaoberfläche nach einem der vorhergehenden Ansprüche, bei dem die Muster identisch und periodisch in zwei Richtungen angeordnet sind, wobei die Periode in jeder Richtung eine Subwellenlänge ist.

7. Optische Metaoberfläche (200), die konfiguriert ist, um in einem vorgegebenen spektralen Nutzungsband (Δλᵤ) betrieben zu werden, wobei die Metaoberfläche aufweist:
- ein Substrat (210),
- eine 2D-Matrix (220) von Nanostrukturen, welche resonante dielektrische Elemente (222) bilden, die in mindestens einem lichtempfindlichen dielektrischen Material gebildet sind, das auf dem Substrat (210) aufgebracht ist; und wobei
- die Nanostrukturen (222) als identische Muster angeordnet sind, die periodisch auf dem Substrat in zwei Richtungen wiederholt werden, mit einer Subwellenlängenperiode in jeder Richtung, wobei jedes Muster eine vorgegebene Brechungsindexänderung in Bezug auf einen Referenzbrechungsindex aufweist, wodurch jedes Muster der 2D-Matrix an einer einfallenden elektromagnetischen Welle mit einer Wellenlänge in dem spektralen Nutzungsband eine Phasenänderung erzeugt, die der Brechungsindexänderung entspricht.

8. Optische Metaoberfläche (200) nach Anspruch 7, wobei die Nanostrukturen (222) aus quaderförmigen oder zylindrischen Plots gebildet sind.

9. System (300) zur Herstellung einer optischen Metaoberfläche (200) für die Durchführung des Herstellungsverfahrens nach einem der Ansprüche 1 bis 6, wobei das System aufweist:
- einen Träger (340), der zur Aufnahme der 2D-Matrix (220) geeignet ist;
- eine Emissionsquelle (310) für eine elektromagnetische Welle (312) mit mindestens einer Wellenlänge in dem lichtempfindlichen Spektralband des mindestens einen lichtempfindlichen dielektrischen Materials;
- eine Beschriftungsvorrichtung (320), die zwischen der Emissionsquelle (310) und dem Träger (340) angeordnet und konfiguriert ist, die Amplitude und/oder die Phase der elektromagnetischen Welle (312) zu modulieren, um die Beschriftungswelle (314) zu erzeugen, die in der Ebene der 2D-Matrix eine räumliche Energieverteilung aufweist, die von dem angestrebten Phasenprofil abhängig ist.

10. Herstellungssystem nach Anspruch 9, wobei die Beschriftungswelle (320) einen räumlichen Modulator für elektromagnetische Wellen aufweist und eine Steuereinheit (325), die so ausgebildet ist, dass sie den räumlichen Modulator steuert.

11. System nach einem der Ansprüche 9 bis 10, das ferner eine optische Vorrichtung (350) aufweist, die derart ausgebildet ist, dass sie die Änderungen des Brechungsindex, die die Muster in mindestens einem Bereich der 2D-Matrix (220) nach der Belichtung erfahren, in Echtzeit überwacht.

## Claims

1. A method (100) for manufacturing an optical metasurface (200) configured to operate in a given working spectral band (Δλᵤ), the method comprising the following steps:
- obtaining (110) a 2D array (220) of patterns, each comprising one or more nanostructures forming dielectric elements (222) that are resonant in said working spectral band, said nanostructures being formed in at least one photosensitive dielectric material, said at least one photosensitive dielectric material having a refractive index that can be varied by exposure to at least one writing electromagnetic wave having a wavelength lying in a photosensitivity spectral band;
- exposing (120) said 2D array to a writing electromagnetic wave (314) having at least one wavelength in said photosensitivity spectral band, said writing wave (314) having a spatial energy distribution in a plane of the 2D array that is a function of an intended phase profile, so that each pattern of the 2D array produces, following said exposure, on an incident electromagnetic wave having a wavelength in the working spectral band, a phase variation corresponding to a refractive index variation experienced by said pattern during said exposure.

2. The method for manufacturing an optical metasurface as claimed in claim 1, wherein the obtaining of the 2D array comprises depositing (112) said at least one photosensitive dielectric material on a substrate (210) and forming (114) said nanostructures in said at least one photosensitive dielectric material.

3. The method for manufacturing an optical metasurface as claimed in claim 1, wherein the obtaining of the 2D array comprises forming said nanostructures in a substrate comprising said at least one photosensitive dielectric material.

4. The method for manufacturing an optical metasurface as claimed in any one of the preceding claims, wherein said phase profile is multilevel.

5. The method for manufacturing an optical metasurface as claimed in any one of the preceding claims, further comprising a step (130) of monitoring in real time the refractive index variations experienced by the patterns of at least one region of the 2D array during said exposure.

6. The method for manufacturing an optical metasurface as claimed in any one of the preceding claims, wherein said patterns are identical and arranged periodically along two directions, the period along each direction being sub-wavelength.

7. An optical metasurface (200) configured to operate in a given working spectral band (Δλᵤ), said metasurface comprising:
- a substrate (210),
- a 2D array (220) of nanostructures forming resonant dielectric elements (222) that are formed in at least one photosensitive dielectric material deposited on said substrate (210); and wherein
- said nanostructures (222) are arranged in the form of identical patterns repeated periodically on the substrate along two directions, with a sub-wavelength period along each direction, each pattern having a given refractive index variation with respect to a reference refractive index, so that each pattern of the 2D array produces, on an incident electromagnetic wave having a wavelength in the working spectral band, a phase variation corresponding to said refractive index variation.

8. The optical metasurface (200) as claimed in claim 7, wherein nanostructures (222) are formed by parallelepipedal or cylindrical blocks.

9. A system (300) for manufacturing an optical metasurface (200) for carrying out the manufacturing method as claimed in any one of claims 1 to 6, the system comprising:
- a support (340) capable of receiving said 2D array (220);
- an emission source (310) of an electromagnetic wave (312) having at least one wavelength in said photosensitivity spectral band of said at least one photosensitive dielectric material;
- a writing device (320) placed between the emission source (310) and the support (340) and configured to modulate the amplitude and/or the phase of the electromagnetic wave (312) in order to form said writing wave (314) having the spatial energy distribution in the plane of the 2D array that is a function of said intended phase profile.

10. The manufacturing system as claimed in claim 9, wherein said writing device (320) comprises a spatial electromagnetic wave modulator and a controller (325) configured to control said spatial modulator.

11. The system as claimed in either one of claims 9 or 10, further comprising an optical device (350) configured to monitor in real time the refractive index variations experienced by said patterns of at least one region of said 2D array (220) during said exposure.
